(19) Europäisches Patentamt
European Patent Office
Office européen des brevets

(11) Publication number : 0 369 444 B1

(12) # EUROPEAN PATENT SPECIFICATION

(45) Date of publication of patent specification : **07.06.95 Bulletin 95/23**

(51) Int. Cl.$^6$ : **G03F 7/00,** G03F 7/038

(21) Application number : **89121223.5**

(22) Date of filing : **16.11.89**

(54) **Photosensitive resin composition and method of preparing volume type phase hologram member using same.**

(30) Priority : **18.11.88 JP 290091/88**
**18.11.88 JP 290092/88**
**18.11.88 JP 290094/88**
**18.11.88 JP 290095/88**
**18.11.88 JP 290097/88**
**18.11.88 JP 290098/88**
**06.10.89 JP 260239/89**

(43) Date of publication of application : **23.05.90 Bulletin 90/21**

(45) Publication of the grant of the patent : **07.06.95 Bulletin 95/23**

(84) Designated Contracting States : **DE FR GB**

(56) References cited :
**EP-A- 0 084 452**
**EP-A- 0 235 038**
**US-A- 3 503 745**
**US-A- 3 728 120**
**PATENT ABSTRACTS OF JAPAN vol. 42, no. 76 (P--675)(2923) 10 March 1988 ; & JP-A-62 215 284**

(73) Proprietor : **CANON KABUSHIKI KAISHA**
**30-2, 3-chome, Shimomaruko,**
**Ohta-ku**
**Tokyo (JP)**

(72) Inventor : **Yoshinaga, Yoko**
**21-19, Haramachida 4-chome**
**Machida-shi Tokyo (JP)**
Inventor : **Taniguchi, Naosato**
**Canon Daiichi Honatsugiryo**
**6-29, Mizuhiki 2-chome**
**Atsugi-shi Kanagawa-ken (JP)**
Inventor : **Kishi, Hiroyoshi**
**19-14, Morinosato 2-chome**
**Atsugi-shi Kanagawa-ken (JP)**
Inventor : **Kuwayama, Tetsuro**
**1-21, Utsukushigaoka**
**Midori-ku**
**Yokohama-shi Kanagawa-ken (JP)**
Inventor : **Kushibiki, Nobuo**
**2-2, Fukuda 5-chome**
**Yamato-shi Kanagawa-ken (JP)**

(74) Representative : **Bühling, Gerhard, Dipl.-Chem. et al**
**Patentanwaltsbüro**
**Tiedtke-Bühling-Kinne & Partner**
**Bavariaring 4**
**D-80336 München (DE)**

EP 0 369 444 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

**Description**

## BACKGROUND OF THE INVENTION

### Field of the invention

The present invention relates to a photosensitive resin composition having a sensitivity to light of a long wavelength, of a laser such as a helium-neon laser or a semiconductor laser, and a method of preparing a volume type phase hologram using the composition.

### Related Background Art

Progression has recently been energetically made on photosensitive materials used for laser beam writing, in the field of image recording techniques of digital systems or in the field of holography techniques.

In particular, there are strong demands for photosensitive resins or photosensitive materials having a sensitivity to long-wavelength light of helium-neon lasers, semiconductor lasers, etc. that ranges from the visible region to the near infrared region.

To satisfy such demands, a proposal has been hitherto made on a photosensitive material used for hologram recording, so prepared as to have a sensitivity to the long-wavelength laser light, as it is seen in Japanese Patent Application Laid-open No. 62-215284, in which it is disclosed a photosensitive material comprising a carbazole ring-containing polymer as a chief agent and a triphenylmethane type dye contained as a photoreaction initiator.

Such a photosensitive material, however, has had the problem that the triphenylmethane type dye can be dissolved in an organic solvent with difficulty. In particular, it has so poor a property of being dissolved in an aromatic solvent that the dye can be removed with difficulty in the processing after exposure.

Such a photosensitive material has also had the problem that it has no sensitivity to the light of semiconductor lasers, which is longer in wavelength than the light of helium-neon lasers.

## SUMMARY OF THE INVENTION

Accordingly, a first object of the present invention is to eliminate the disadvantages in the above prior art to provide a novel photosensitive resin composition having a high sensitivity to long-wavelength laser light.

A second object of the present invention is to provide a method of preparing a volume type phase hologram that uses the long-wavelength laser light, while keeping the advantages of the above novel photosensitive resin composition.

The present invention provides a photosensitive resin composition comprising;

(a) a polyvinylcarbazole type polymer;

(b) a halogen-containing compound; and

(c) at least one compound selected from the group consisting of a triarylhydrazyl, a triarylcarbonium type coloring matter having at least one carbazolyl group, and a reaction product between a styryl base and a hologenated hydrocarbon.

The present invention also provides a photosensitive material comprising a photosensitive layer containing;

(a) a polyvinylcarbazole type polymer;

(b) a halogen-containing compound; and

(c) at least one compound selected from the group consisting of a triarylhydrazyl, a triarylcarbonium type coloring matter having at least one carbazolyl group, and a reaction product of a styryl base with a halogenated hydrocarbon.

The present invention still also provides a method of preparing a volume type phase hologram, which method comprises the steps of: subjecting a photosensitive material to exposure using a laser beam to form an interference pattern; and subjecting the photosensitive material thus exposed to light to development processing using a solvent, wherein said photosensitive material has a photosensitive layer comprising a resin composition containing;

(a) a polyvinylcarbazole type polymer;

(b) a halogen-containing compound; and

(c) at least one compound selected from the group consisting of a triarylhydrazyl, a triarylcarbonium type coloring matter having at least one carbazolyl group, and a reaction product of a styryl base and a halogenated hydrocarbon.

## BRIEF DESCRIPTION OF THE DRAWINGS

Fig. 1 shows visible light absorption spectra in an example of the present invention;

Fig. 2 schematically illustrates an optical system utilized in the method of preparing a hologram according to the present invention;

Fig. 3 shows visible light absorption spectra in an example of the present invention and a comparative example; and

Fig. 4 shows a visible light absorption spectrum of a certain sensitizer used in the present invention.

## DETAILED DESCRIPTION OF THE PREFERRED EMBODIMENTS

The polyvinylcarbazole (hereinafter "PVCz") type polymer refers to a polymer produced by polymerizing a composition mainly composed of a monomer such as vinylcarbazole, an alkyl-substituted derivative thereof or a halogen-substituted derivative thereof, or an acrylic acid derivative or vinyl acetate derivative having a carbazole group at its side chain. It specifically includes, for example, PVCz, 3-chlorovinylcarbazole polymer, 3-bromovinylcarbazole polymer, 3-iodovinylcarbazole polymer, 3-methylvinylcarbazole polymer,3-ethylvinylcarbazole polymer, chlorinated PVCz, brominated PVCz, and a polymer made from a monomer represented by the following structural formula (I) or (II).

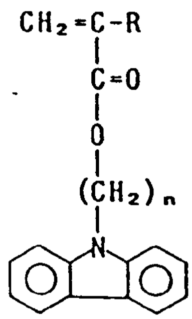

(I)

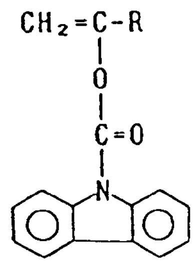

(II)

Of these, the unsubstituted PVCz is virtually optimum since it is readily available and also can give a photosensitive resin composition with a particularly superior performance.

The above PVCz polymers may optionally be copolymerized with additional monomers for the purpose of, for example, controlling properties such as strength and flexibility required when they are formed into films. The additional monomers used for such purpose include, for example, in addition to the above vinylcarbazoles, vinyl esters such as vinyl acetate, an ester of acrylic acid or methacrylic acid, in particular, the esters represented by the above structural formula (I) or (II), and vinyl type monomers such as styrene and styrene derivatives. These monomers are copolymerizable by copolymerization. It is also possible to use other polymers as exemplified by polystyrene, a styrene/butadiene copolymer and a styrene/hydrogenated butadiene copolymer, which may be blended within the range such that may not lower the sensitivity and can achieve recording. These are used by selecting the proportion of addition so that the desired properties can be obtained.

The polymer component mainly composing the photosensitive resin composition of the present invention is required to have previously been made active to radiations, using a halogen-containing compound, preferably an iodine-containing compound and/or a bromine-containing compound. Preferred examples of such a halogen-containing compound include iodine-containing compounds and bromine-containing compounds such as carbon tetraiodide, iodoform, ethylene tetraiodide, triiodoethane, tetraiodoethane, pentaiodoethane, hexaiodoethane, carbon tetrabromide, and ethylene tetrabromide. These halogen-containing compounds are added to the above polymer in the proportion of from 1 to 100 % by weight, and preferably from 3 to 25 % by weight, based on the above PVCz polymer. The addition of the halogen-containing compound as described above at an excessively small amount may bring about so low a sensitivity of the resulting composition that the exposure may require a long time undesirably. On the other hand, the addition at an excessively large amount may make undecomposed halogen-containing compounds left in the composition, thus making it necessary to remove all of them in a post-treatment, and further undesirably bringing about a cause to produce voids in the hologram.

In the present invention, the above PVCz polymer and halogen-containing compound are used in combination with a sensitizer having properties of absorbing long wavelength light and sensitizing the halogen-containing compound, which is as exemplified by the following sensitizers (I), (II) and (III).

The sensitizer (I) includes a triarylhydrazyl represented by the following structural formula:

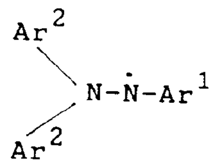

wherein $Ar^1$ and $Ar^2$ represent independently a substituted or unsubstituted aryl group.

More preferably, it may include the sensitizer having an electron accepting group such as a nitro group, a sulfonic acid group or an alkoxycarbonyl group at the ortho position or further at the para position of $Ar^1$ in the above formula. (At the meta position, either an electron-accepting group or an electron-donating group may be present.)

$Ar^2$ in the above formula may also have 1 to 3 substituents such as halogen atoms, lower alkyl groups, alkoxycarbonyl groups, hydroxyl groups, and alkoxy groups.

In the present invention, particularly preferred examples of the compound of the above formula include the following compounds:

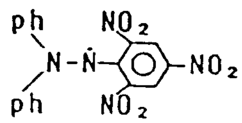 (I-1)

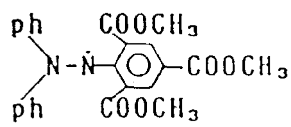 (I-2)

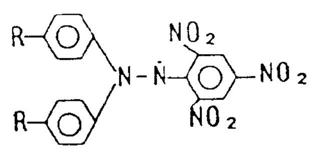 (I-3)

In the above structural formulas, R represents a substituent such as a halogen atom, a lower alkyl group, an alkoxycarbonyl group, a hydroxyl group or an alkoxy group; and Ph represents a phenyl group.

The triarylhydrazyl as described above can be prepared, for example, by the method as disclosed in J.K. Kochi, Free Radical, p.557.

The sensitizer (II) may include a triarylcarbonium type coloring matter represented by the following structural formula:

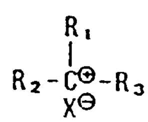

$R_1$ to $R_3$ in the above formula represent independently an aromatic group having a halogen atom, an alkyl group such as a methyl group or an ethyl group, an alkoxy group such as a methoxy group or an ethoxy group, an amino group, a substituted amino group such as a monomethylamino group, a monoethylamino group, a dimethylamino group or a diethylamino group, a carboxyl group, or a sulfonic acid group, provided that at least one of $R_1$, $R_2$ and $R_3$ is a carbazolyl group; and X represents an anion such as chloride, bromide, iodide, chlorate or tetrafluoroborate.

A triarylcarbonyl type coloring matter particularly preferred in the present invention is a compound in which at least one of the above three $R_1$, $R_2$, $R_3$ groups is a carbazolyl group of the following formula:

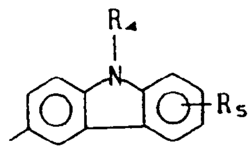

$R_4$ in the above formula represents a hydrogen atom, an alkyl group such as a methyl group or an ethyl group, or an alkyl halide group such as an ethyl iodide group; $R_5$ represents a hydrogen atom, a halogen atom, an alkyl group such as a methyl group or an ethyl group, an alkoxy group such as a methoxy group or an ethoxy group.

Particularly preferred examples of the triarylcarbonium type coloring matters include the following:

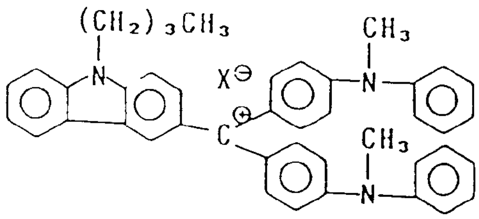

(II-1)

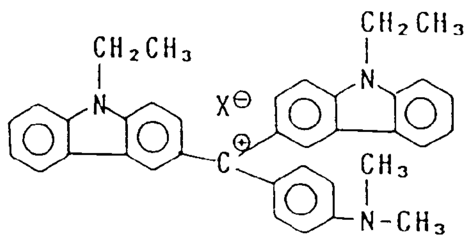

(II-2)

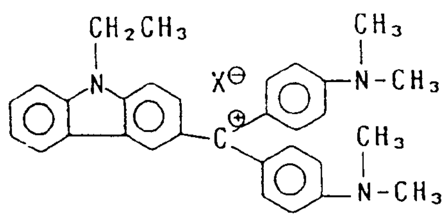

(II-3)

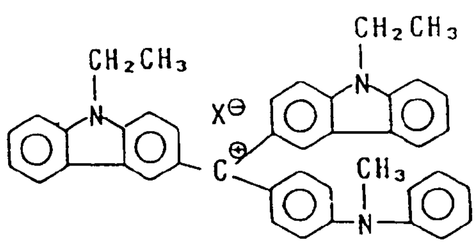

(II-4)

X in the above formulas is as defined above.

It may also include triarylcarbonium type coloring matters known to be formed by carbazole and a halogenated methane.

The sensitizer (III) used in the present invention is a coloring matter known to be formed as a result of the photoreaction of a styryl base such as a styryl group-bonded heterocyclic compound, with a hydrocarbon halide, particularly including carbon tetraiodide, iodoform, ethylene tetraiodide, triiodoethane, tetraiodoethane,

pentaiodoethane, hexaiodoethane, carbon tetrabromide, ethylene tetrabromide, and methyl iodide, ethyl iodide, butyl iodide, octyl iodide and the corresponding bromides.

The styryl base used in the above reaction may specifically include, for example, dye precursors represented by the following structural formula:

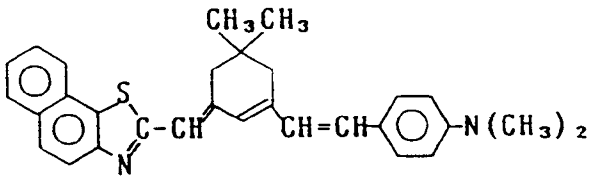

(III-1)

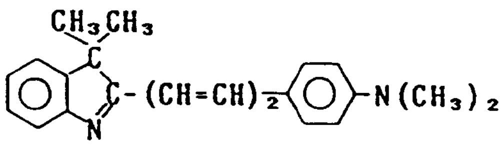

(III-2)

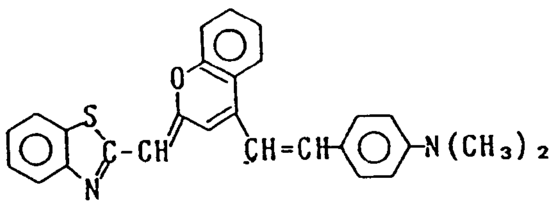

(III-3)

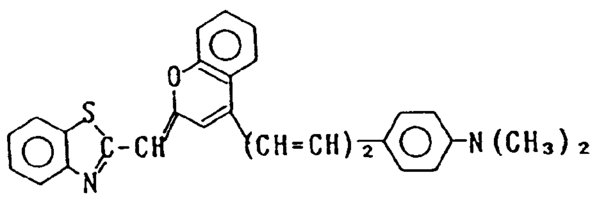

(III-4)

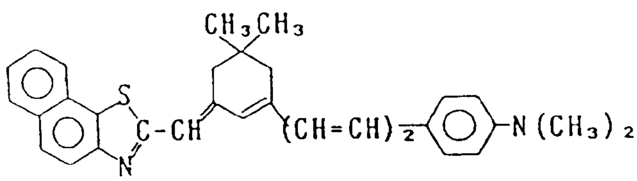

(III-5)

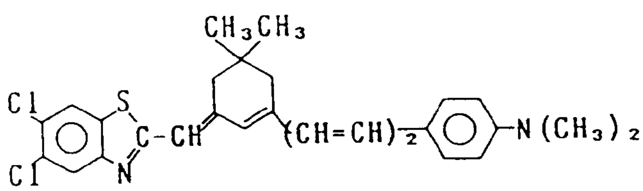

(III-6)

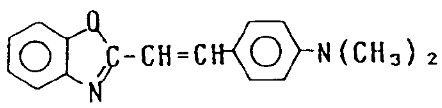

(III-7)

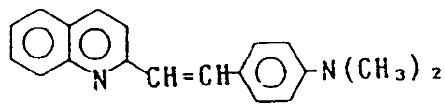

(III-8)

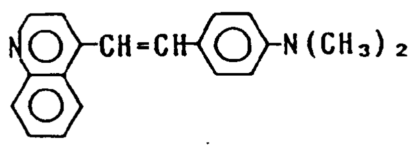

(III-9)

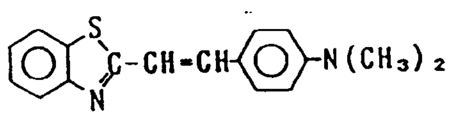

(III-10);

and

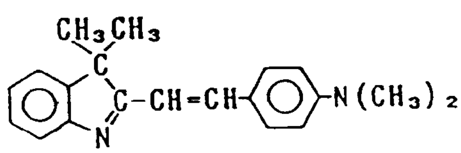

(III-11)

The sensitizers (I), (II) and (III) used in the present invention may be added in the proportion of from 0.01 to 25 % by weight, and preferably from 0.1 to 10 % by weight, based on the polymer to the photosensitive resin composition. Addition thereof in an amount less than the above range may result in an insufficient sensitizing action. On the other hand, use thereof in an amount more than the above range may bring about no improvement in sensitizing action with an increase in the amount, and may also cause the problem of generation of voids, undesirably.

The photosensitive resin composition of the present invention can be obtained by dissolving the above PVCz polymer, such a halogen-containing compound and a sensitizer in a good solvent for the PVCz polymer. Taking account of the solubility to the PVCz polymer, boiling point, etc., preferred solvents include benzene, xylene, chlorobenzene, chloroform, dichloroethane, dichloroethylene, trichloroethylene, pyridine, dioxane, tetrahydrofuran, or a mixture of any of these.

The PVCz polymer may be dissolved by usual operation without any particular limitations, e.g., by putting it in the above organic solvent, optionally followed by heating, filtration to remove insoluble matters, and leaving

to remove air bubbles.

The photosensitive resin composition of the present invention may be in the form of the above solution, or may also be in the form of a film. When it is in the form of a film, it can be obtained by preparing a solution of the photosensitive resin composition described above, and coating the solution on a suitable substrate such as a glass sheet or a plastic film sheet, followed by drying to form a coating film. The film thus obtained may preferably have a thickness of from 1 to 40 μm, more preferably 5 to 20 μm, as a dried film thickness. It may remain supported on the substrate or may be in a peeled state.

The above-described photosensitive resin composition of the present invention is sufficiently sensitive to the light of helium-neon lasers which are simple in mechanism and also inexpensive, and also responsive to the light of semiconductor lasers. Thus, the present composition is useful in forming a volume type phase hologram, a light-scattering pattern, a relief pattern, etc.

As an example of the use of the above photosensitive resin composition of the present invention, an instance in which it is used in hologram recording will be described below.

A hologram recording medium comprising the photosensitive resin composition of the present invention can be obtained by preparing a solution of the photosensitive resin composition described above, and applying the solution to a suitable substrate such as a glass sheet or a plastic film sheet to form a coating film thereon.

The recording medium thus formed is exposed to light in an optical system as shown in Fig. 2, using two beams of coherent light from a laser, i.e., the object beam and the reference beam which are coherent visible light of up to 830 nm.

A subsequent developing process comprises two steps of a swelling step and a shrinking step.

More specifically, a recording layer on which a hologram latent image has been formed through the above exposure step is processed with a swelling solution serving as a first solvent, to cause the recording layer to be swelled corresponding to the hologram pattern formed, and the recording layer in the swelled state is shrinked by the subsequent processing with a second solvent. Thus, a hologram is amplified and fixed.

The first solvent used in the swelling step includes, for example, benzene, toluene, xylene (an ortho isomer, a meta isomer, a para isomer, and a mixture of these), benzene and naphthalene derivatives such as ethylbenzene, n-propylbenzene, cumene, phenol, cresol, chlorobenzene, dichlorobenzene,nitrobenzene, benzyl alcohol, benzyl chloride, benzyl bromide, α-methylnaphthalene and α-chloronaphthalene, pyran, and halogen-substituted and saturated or unsaturated hydrocarbons such as dichloromethane, chloroform, trichloroethylene, trichloroethane, dichloroethane and bromoform.

The second solvent used in the shrinking step includes, for example, alkanes or cycloalkanes such as n-pentane, n-hexane, n-heptane, n-octane, isooctane and cyclohexane, alcohols such as methyl alcohol, ethyl alcohol, n-propyl alcohol, isopropyl alcohol, n-butyl alcohol, tert-butyl alcohol, n-amyl alcohol and isoamyl alcohol, and ethers such as diethyl ether, methyl ethyl ether and diisopropyl ether. The swelling and shrinking processing can also be used by mixing the above first solvent and second solvent in an appropriate proportion.

The volume type phase hologram thus obtained has various superior performances such as light-resistance, moisture resistance, diffraction efficiency, transparency and low haze, and can be satisfactorily used for various purposes in the state it remains adhered on the substrate, or as a hologram film peeled from the substrate.

## EXAMPLES

The present invention will be described below in greater detail by giving Examples and Comparative Examples.

### Example 1

In 60 g of chlorobenzene, 4.5 g of PVCz (Luvican; a product of BASF), 0.3 g of carbon tetraiodide and 0.15 g of the above exemplary (I-1) triarylhydrazyl (DPPH: diphenylpicrylhydrazyl) were dissolved in the dark to give a solution-like photosensitive resin composition. This photosensitive resin composition, the spectra of which are as shown in Fig. 1, shows a decay in the absorption of carbon tetrachloride having a peak at 380 nm, when irradiated with helium-neon laser beams (wavelength: 632.8 nm). After the reaction the polymer is cross-linked and turns insoluble.

A 100 μm thick polyester film base was coated with the above composition so as to give a dried film thickness of 2 μm, followed by drying to form a photosensitive resin composition film.

A negative film was brought into close contact with the resulting film, which was then exposed to light at 150 $mJ/cm^2$ using a helium-neon laser (wavelength: 632.8 nm).

Next, the above film was immersed in a benzene solvent for 5 seconds, and thereafter immersed in methyl

alcohol for 5 seconds, followed by drying. As a result, unexposed areas turned opaque, and, when viewed by reflection, a sharp positive and visible pattern was obtained.

Example 2

In Example 1, the processing using the benzene solvent was carried out for 3 minutes. As a result, unexposed areas were dissolved away, and a transparent relief pattern was formed after drying.

Examples 3 to 6

Using the same recording medium as in Example 1, positive and visible patterns were formed using lasers of different wavelengths as shown below. In each Example, a sharp positive pattern was obtained in the amount of exposure as shown below.

| Example No. | Laser | Wavelength | Amount of exposure |
|---|---|---|---|
| | | (nm) | ($mJ/cm^2$) |
| 3 | Argon | 514.5 | 100 |
| 4 | Ruby | 694.3 | 200 |
| 5 | Semiconductor | 780 | 280 |
| 6 | Semiconductor | 830 | 300 |

Examples 7 & 8

Using photosensitive material components different from those used in Example 1, positive and visible patterns were formed according to the same method as in Example 4. Each amount of exposure is shown below.

| Example No. | Photosensitive material components | Amount of exposure |
|---|---|---|
| | | ($mJ/cm^2$) |
| 7 | Triarylhydrazyl(I-2) + $CI_4$ | 250 |
| 8 | Triarylhydrazyl(I-3) + $CI_4$ | 200 |

Example 9

In 60 g of chlorobenzene, 4.5 g of PVCz (Luvican M-170; a product of BASF), 0.3 g of carbon tetraiodide and 0.15 g of the above exemplary (II-1) triarylcarbonium coloring matter ($X = I^-$) were dissolved in the dark to give a solution-like photosensitive resin composition.

A 100 μm thick polyester film base was coated with the above composition so as to give a dried film thick-

ness of 2 μm, followed by drying to form a photosensitive resin composition film.

A negative film was brought into close contact with the resulting film, which was then exposed to light at 100 mJ/cm$^2$ using a helium-neon laser (wavelength: 632.8 nm).

Next, the above film was immersed in a benzene solvent for 5 seconds, and thereafter immersed in methyl alcohol for 5 seconds, followed by drying. As a result, unexposed areas turned opaque, and, when viewed by reflection, a sharp positive and visible pattern was obtained.

Example 10

In Example 9, the processing using the benzene solvent was carried out for 3 minutes. As a result, unexposed areas were dissolved away, and a transparent relief pattern was formed after drying.

Examples 11 to 13

Using the same recording medium as in Example 9, positive and visible patterns were formed using lasers of different wavelengths as shown below. Results obtained are shown below.

| Example No. | Laser | Wavelength (nm) | Amount of exposure (mJ/cm$^2$) |
|---|---|---|---|
| 11 | Ruby | 694.3 | 130 |
| 12 | Semiconductor | 780 | 200 |
| 13 | Semiconductor | 830 | 320 |

Examples 14 to 17

Using photosensitive material components different from those used in Example 9, positive and visible patterns were formed according to the same method as in Example 9. Results obtained are shown below.

| Example No. | Photosensitive material components | Amount of exposure (mJ/cm$^2$) |
|---|---|---|
| 14 | Triarylcarbonium(II-2) + $CI_4$ | 130 |
| 15 | Triarylcarbonium(II-3) + $CI_4$ | 150 |
| 16 | Triarylcarbonium(II-4) + $CI_4$ | 100 |
| 17 | (Reaction product of ethylcarbazole with $CI_4$) + $CI_4$ | 100 |

In Example 17, the reaction product of ethylcarbazole with $CI_4$ was formed by dissolving ethylcarbazole

(0.6 g) and carbon tetraiodide (0.2 g) in 300 mℓ of benzene, followed by exposure using a high-pressure mercury lamp (500 W). The resulting coloring matter was used after removal of the solvent, but without purification. The spectrum obtained is shown in Fig. 4

Example 18

In 60 g of chlorobenzene, 4.5 g of PVCz (Luvican M-170; a product of BASF), 0.3 g of carbon tetraiodide and 0.15 g of a photoreaction product of a styryl base [the above exemplary dye (III-3)] with iodoform in a molar ratio of 1:1 were dissolved in the dark to give a solution-like photosensitive resin composition.

The reaction product of the styryl base [the above exemplary dye (III-3)] with iodoform was formed by dissolving the styryl base and iodoform in a molar ratio of 1:1 in a benzene-ethanol mixed solution, followed by exposure using a high-pressure mercury lamp (500 W). The reaction process was traced by the measurement of the shift of a peak to the long wavelength side, based on the visible absorption spectrum. The resulting coloring matter was used after removal of the solvent, but without purification.

A 100 μm thick polyester film base was coated with the above composition so as to give a dried film thickness of 2 μm, followed by drying to form a photosensitive resin composition film.

A negative film was brought into close contact with the resulting film, which was then exposed to light at 150 mJ/cm$^2$ using a helium-neon laser (wavelength: 632.8 nm).

Next, the above film was immersed in a benzene solvent for 5 seconds, and thereafter immersed in methyl alcohol for 5 seconds, followed by drying. As a result, unexposed areas turned opaque, and, when viewed by reflection, a sharp positive visible pattern was obtained.

Example 19

In Example 18, the processing using the benzene solvent was carried out for 3 minutes. As a result, unexposed areas were dissolved away, and a transparent relief pattern was formed after drying.

Examples 20 to 22

Using the same recording medium as in Example 18, positive and visible patterns were formed using lasers of different wavelengths as shown below. Results obtained are shown below.

| Example No. | Laser | Wavelength (nm) | Amount of exposure (mJ/cm$^2$) |
|---|---|---|---|
| 20 | Argon | 514.5 | 180 |
| 21 | Ruby | 694.3 | 250 |
| 22 | Semiconductor | 780 | 300 |

Example 23

Using photosensitive material components different from those used in Example 18, positive and visible patterns were formed according to to the same method as in Example 18. Results obtained are shown below.

| Styryl base photoreaction product | Carbon halide | Amount of exposure |
|---|---|---|
| | | ($mJ/cm^2$) |
| (III-2) | $CI_4$ | 130 |
| (III-3) | $CI_4$ | 130 |
| (III-4) | $CI_4$ | 170 |
| (III-5) | $CI_4$ | 150 |
| (III-6) | $CI_4$ | 100 |
| (III-7) | $CI_4$ | 130 |
| (III-8) | $CI_4$ | 150 |
| (III-9) | $CI_4$ | 150 |

Example 24

In 60 g of chlorobenzene, 4.5 g of PVCz (Luvican M-170; a product of BASF), 0.3 g of carbon tetraiodide and 0.15 g of the above exemplary (I-1) triarylhydrazyl (DPPH: diphenylpicrylhydrazyl) were dissolved in the dark. A cleaned glass sheet was coated with the resulting solution, using a spinner, followed by drying to form a recording layer of 7.2 μm thick. This recording layer was exposed to light at 200 $mJ/cm^2$ using a helium-neon laser (wavelength: 632.8 nm). A hologram was thus recorded.

After the exposure, the resulting recording material was immersed in 30°C xylene for 1 minute, and thereafter immersed in n-heptane for 1 minute, followed by drying to obtain a volume type phase hologram. The diffraction efficiency of this hologram was measured by means of a spectrophotometer to which a reflection unit was connected. As a result, the hologram was found to have a maximum diffraction efficiency of 75 % at 649 nm.

Examples 25 to 28

Using the same recording medium as in Example 24, holograms were made in the same manner as in Example 24 except for using lasers of different wavelengths as shown below. Results obtained are shown below.

| Example No. | Laser | Recording wavelength | Amount of exposure | Diffraction wavelength | Diffraction efficiency |
|---|---|---|---|---|---|
| 25 | Argon | 514.5nm | $100mJ/cm^2$ | 530nm | 85% |
| 26 | Ruby | 694.3nm | $100mJ/cm^2$ | 730nm | 50% |
| 27 | SemiCD* | 780nm | $300mJ/cm^2$ | 790nm | 40% |
| 28 | SemiCD* | 830nm | $300mJ/cm^2$ | 850nm | 20% |

* Semiconductor

Examples 29 to 32

Using photosensitive material components different from those used in Example 24, holograms were made according to the same method as in Example 24. Results obtained are shown below.

| Example No. | Photosensitive material components | Diffraction wavelength | Diffraction efficiency |
|---|---|---|---|
| 29 | Triarylhydrazyl(I-2)+$CI_4$ | 640nm | 70% |
| 30 | Triarylhydrazyl(1-2)+$CHI_3$ | 640nm | 50% |
| 31 | Triarylhydrazyl(I-3)+$CI_4$ | 640nm | 73% |
| 32 | Triarylhydrazyl(I-3)+$CHI_3$ | 640nm | 55% |

Comparative Example 1

Examples 26, 27 and 28 were repeated to carry out recording, except for using Crystal Violet in place of DPPH. As a result, no holograms were formed.

Comparative Example 2

Using Crystal Violet in place of DPPH, recording was effected in the same manner as in Example 24. As a result, a broad absorption originating from Crystal Violet was observed around 580 nm, as shown in Fig. 3, and the coloring matter was not completely removed in the developing step. In Fig. 3, the solid line indicates the visible light absorption spectrum according to the present Comparative Example, and the dotted line, the visible light absorption spectrum according to Example 24 which exhibited only diffraction efficiency.

Example 33

In 60 g of chlorobenzene, 4.5 g of PVCz (Luvican M-170; a product of BASF), 0.3 g of carbon tetraiodide and 0.15 g of the above exemplary (II-1) triarylcarbonium coloring matter ($X = I^-$) were dissolved in the dark. A cleaned glass sheet was coated with the resulting solution, using a spinner, followed by drying to form a recording layer of 7.2 μm thick. This recording layer was exposed to light using a helium-neon laser (wavelength:

632.8 nm). A hologram was thus recorded.

After the exposure, the resulting recording material was immersed in 30°C xylene for 1 minute, and thereafter immersed in n-heptane for 1 minute, followed by drying to obtain a volume type phase hologram. The diffraction efficiency of this hologram was measured by means of a spectrophotometer to which a reflection unit was connected. As a result, the hologram was found to have a maximum diffraction efficiency of 75 % at 649 nm.

Examples 34 to 37

Using the same recording medium as in Example 33, holograms were made by using lasers of different wavelengths as exemplified below. Results obtained are shown below.

| Example No. | Laser | Recording wavelength | Amount of exposure | Diffraction wavelength | Diffraction efficiency |
|---|---|---|---|---|---|
| 34 | Argon | 514.5nm | $100mJ/cm^2$ | 530nm | 80% |
| 35 | Ruby | 694.3nm | $100mJ/cm^2$ | 720nm | 63% |
| 36 | SemiCD* | 780nm | $200mJ/cm^2$ | 800nm | 40% |
| 37 | SemiCD* | 830nm | $300mJ/cm^2$ | 850nm | 25% |

* Semiconductor

Examples 38 to 46

Procedure of Example 33 was repeated to make holograms, except for using photosensitive material components different from those used in Example 33. Results obtained are shown in the following table.

| Example No. | Photosensitive material components | Diffraction wavelength | Diffraction efficiency |
|---|---|---|---|
| 38 | Triarylcarbonium(II-1)+$CHI_3$ | 649nm | 60% |
| 39 | Triarylcarbonium(II-2)+$CI_4$ | 645nm | 72% |
| 40 | Triarylcarbonium(II-2)+$CHI_3$ | 645nm | 55% |
| 41 | Triarylcarbonium(II-3)+$CI_4$ | 640nm | 70% |
| 42 | Triarylcarbonium(II-3)+$CHI_3$ | 640nm | 52% |
| 43 | Triarylcarbonium(II-4)+$CI_4$ | 647nm | 75% |
| 44 | Triarylcarbonium(II-4)+$CHI_3$ | 647nm | 54% |
| 45 | (Reaction product of ethylcarbazole with $CI_4$)+$CI_4$ | 650nm | 75% |
| 46 | (Reaction product of ethylcarbazole with $CI_4$)+$CHI_3$ | 650nm | 58% |

Comparative Example 3

Examples 35, 36 and 37 were repeated to carry out recording, except for using Crystal Violet in place of triarylcarbonium dye (II-1). As a result, no holograms were formed.

Example 47

In 60 g of chlorobenzene, 4.5 g of PVCz (Luvican M-170; a product of BASF), 0.3 g of carbon tetraiodide and 0.15 g of a photoreaction product formed by irradiating with ultraviolet rays a benzene solution of a styryl base [the above exemplary dye (III-3)] and carbon tetraiodide in a molar ratio of 1:1, were dissolved in the dark. A cleaned glass sheet was coated with the resulting solution, using a spinner, followed by drying to form a recording layer of 9.0 μm thick. This recording layer was exposed to light using a helium-neon laser (wavelength: 632.8 nm). A hologram was thus recorded.

After the exposure, the resulting recording material was immersed in 32°C toluene for 1 minute, and thereafter immersed in n-heptane for 1 minute, followed by drying to obtain a volume type phase hologram. The diffraction efficiency of this hologram was measured by means of a spectrophotometer to which a reflection unit was connected. As a result, the hologram was found to have a maximum diffraction efficiency of 80 % at 630 nm.

Examples 48 to 50

Using the same recording medium as in Example 47, holograms were respectively made by using lasers of different wavelengths as exemplified below. Results obtained are shown below.

| Example No. | Laser | Recording wavelength | Amount of exposure | Diffraction wavelength | Diffraction efficiency |
|---|---|---|---|---|---|
| 48 | Argon | 514.5nm | $100nJ/cm^2$ | 530nm | 85% |
| 49 | Ruby | 694.3nm | $200nJ/cm^2$ | 730nm | 40% |
| 50 | SemiCD* | 780.3nm | $300nJ/cm^2$ | 790nm | 35% |

* Semiconductor

Examples 51 to 55

Procedure of Example 47 was repeated to make holograms, except for using photosensitive material components different from those used in Example 33. Results obtained are shown below.

| Example No. | Styryl dye photoreacton product | Carbon halide | Diffraction wavelength | Diffraction efficiency |
|---|---|---|---|---|
| 51 | [(III-1) + $CHI_3$] | $CI_4$ | 640 | 80 |
| 52 | [(III-1) + $ICH_3$] | $CI_4$ | 640 | 83 |
| 53 | [(III-1) + $ICH_3$] | $CHI_3$ | 635 | 67 |
| 54 | [(III-2) + $CI_4$)] | $CI_4$ | 635 | 60 |
| 55 | [(III-3) + $CI_4$)] | $CI_4$ | 635 | 54 |

Comparative Example 4

Examples 49 and 50 were repeated to carry out recording, except for using Crystal Violet in place of the styryl base photoreaction product. As a result, no holograms were recorded.

**Claims**

1. A photosensitive resin composition comprising;
   (a) a polyvinylcarbazole type polymer;
   (b) a halogen-containing compound; and
   (c) at least one compound selected from the group consisting of a triarylhydrazyl, a triarylcarbonium type coloring matter having at least one carbazolyl group, and a reaction product of a styryl base with a halogenated hydrocarbon.

2. A photosensitive resin composition according to Claim 1, wherein said composition has a sensitivity to light of from visible to near infrared wavelength regions.

3. A photosensitive resin composition according to Claim 1, wherein said component (a), component (b) and

component (c) are dissolved in a solvent.

4. A photosensitive resin composition according to Claim 1, wherein said composition is in the form of a film.

5. A photosensitive resin composition according to Claim 1, wherein said component (b) is contained in the proportion of from 3 to 25 % by weight based on said component (a).

6. A photosensitive resin composition according to Claim 1, wherein said component (c) is contained in the proportion of from 0.01 to 25 % by weight based on said component (a).

7. A photosensitive resin composition according to Claim 1, wherein said triarylhydrazyl is a compound represented by the following structural formula:

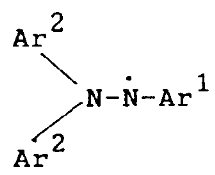

wherein $Ar^1$ and $Ar^2$ represent independently a substituted or unsubstituted aryl group.

8. A photosensitive resin composition according to Claim 1, wherein said triarylhydrazyl is any of the compounds of the following formulas (I-1), (I-2) and (I-3):

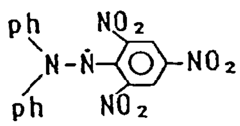

(I-1)

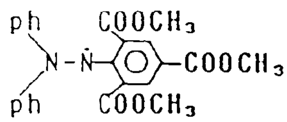

(I-2)

(I-3)

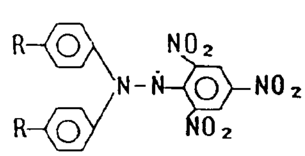

wherein R represents a substituent such as a halogen atom, a lower alkyl group, an alkoxycarbonyl group, a hydroxyl group and an alkoxy group; and ph represents a phenyl group.

9. A photosensitive resin composition according to Claim 1, wherein said triarylcarbonium type coloring matter is a compound represented by the following structural formula:

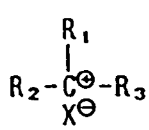

wherein $R_1$ to $R_3$ represent independently an aromatic group having a halogen atom, an alkyl group such as a methyl group and an ethyl group, an alkoxy group such as a methoxy group and an ethoxy group, an amino group, a substituted amino group such as a monomethylamino group, a monoethylamino group, a dimethylamino group and a diethylamino group, a carboxyl group, or a sulfonic acid group, provided that

at least one of $R_1$, $R_2$ and $R_3$ is a carbazolyl group; and X represents an anion such as chloride, bromide, iodide, chlorate, and tetrafluoroborate.

**10.** A photosensitive resin composition according to Claim 1, wherein said triarylcarbonium type coloring matter is any of the compounds of the following formulas (II-1), (II-2), (II-3) and (II-4):

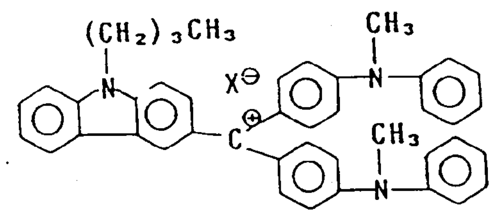

(II-1)

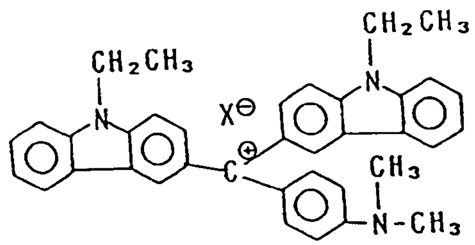

(II-2)

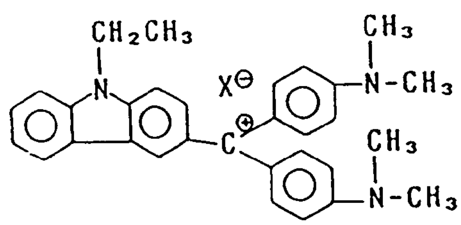

(II-3)

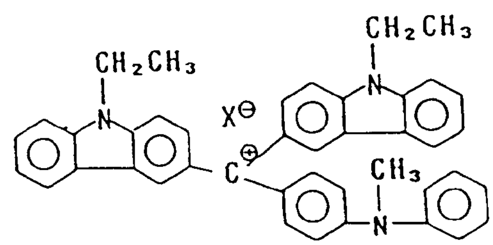

(II-4)

wherein X represents an anion such as chloride, bromide, iodide, chlorate and tetrafluoroborate.

**11.** A photosensitive resin composition according to Claim 1, wherein said styryl base is any of the compounds of the following formulas.

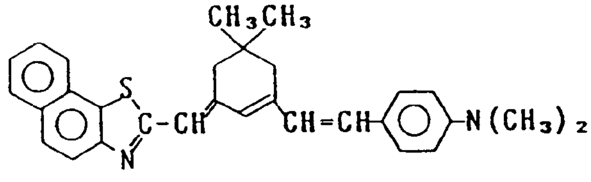

(III-1)

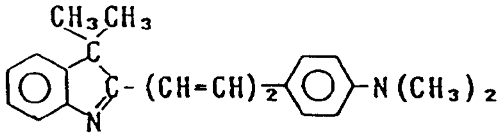

(III-2)

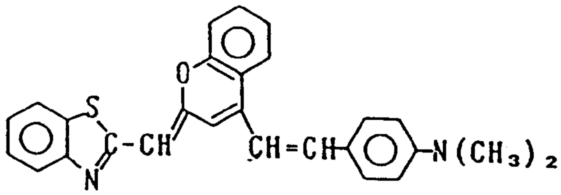

(III-3)

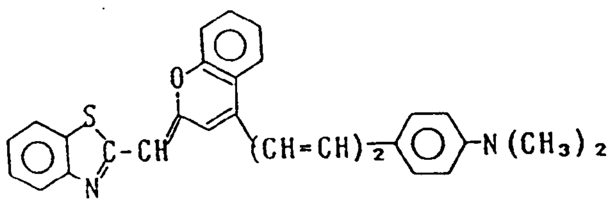

(III-4)

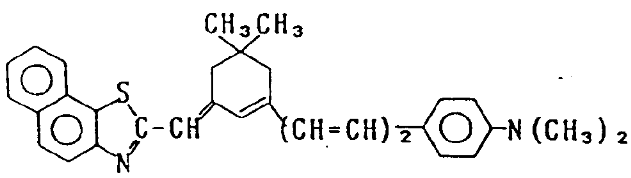

(III-5)

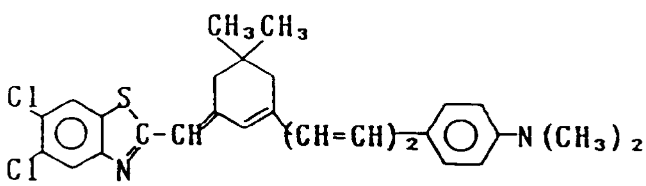

(III-6)

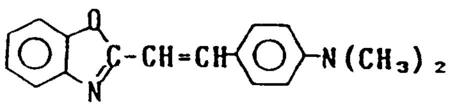

(III-7)

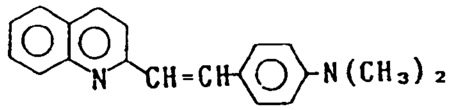

(III-8)

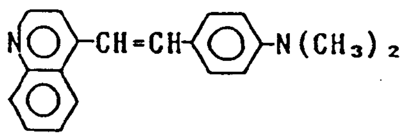

(III-9)

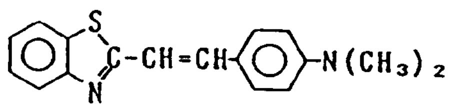

(III-10)

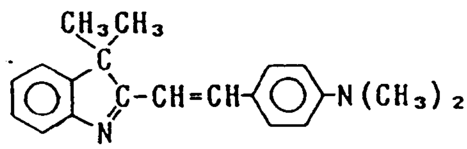

(III-11)

**12.** A photosensitive material comprising a photosensitive layer comprising a resin composition according to claim 1.

**13.** A photosensitive material according to Claim 12, wherein said photosensitive layer is provided to have a thickness of from 1 µm to 40 µm as a dried film thickness.

**14.** A photosensitive material according to Claim 12, wherein said photosensitive layer is provided on a substrate.

**15.** A photosensitive material according to Claim 12, wherein said photosensitive layer comprises a coating film.

**16.** A photosensitive material according to Claim 12, which is in the form of a film.

**17.** A photosensitive material according to Claim 12, wherein said photosensitive layer has a sensitivity to light of from visible to near infrared wavelength regions.

**18.** A photosensitive material according to Claim 12, wherein said photosensitive layer has a sensitivity to light of a wavelength region of from 514.5 nm to 830 nm.

**19.** A photosensitive material according to Claim 12, wherein said component (b) is contained in the proportion of from 3 to 25 % by weight based on said component (a).

**20.** A photosensitive material according to Claim 12, wherein said component (c) is contained in the proportion

of from 0.01 to 25 % by weight based on said component (a).

**21.** A photosensitive material according to Claim 12, wherein said triarylhydrazyl is a compound represented by the following structural formula:

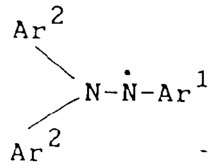

wherein $Ar^1$ and $Ar^2$ represent independently a substituted or unsubstituted aryl group.

**22.** A photosensitive material according to Claim 12, wherein said triarylhydrazyl is any of the compounds of the following formulas (I-1), (I-2) and (I-3):

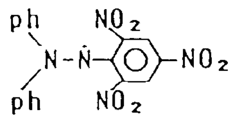

(I-1)

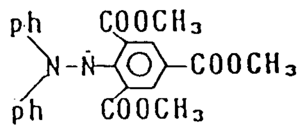

(I-2)

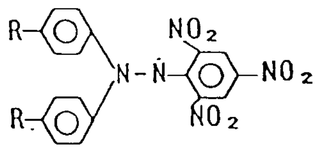

(I-3)

wherein R represents a substituent such as a halogen atom, a lower alkyl group, an alkoxycarbonyl group, a hydroxyl group and an alkoxy group; and ph represents a phenyl group.

**23.** A photosensitive material according to Claim 12, wherein said triarylcarbonium type coloring matter is a compound represented by the following structural formula:

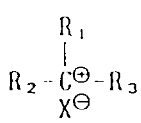

wherein $R_1$ to $R_3$ represent independently an aromatic group having a halogen atom, an alkyl group such as a methyl group and an ethyl group, an alkoxy group such as a methoxy group and an ethoxy group, an amino group, a substituted amino group such as a monomethylamino group, a monoethylamino group, a dimethylamino group and a diethylamino group, a carboxyl group, or a sulfonic acid group, provided that at least one of $R_1$, $R_2$ and $R_3$ is a carbazolyl group; and X represents an anion such as chloride, bromide, iodide, chlorate, and tetrafluoroborate.

**24.** A photosensitive material according to Claim 12, wherein said triarylcarbonium type coloring matter is any of the compounds of the following formulas (II-1), (II-2), (II-3) and (II-4):

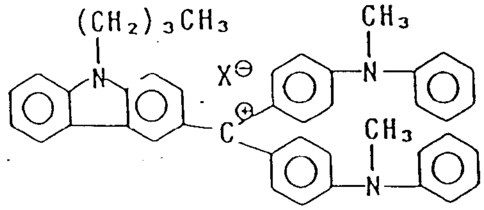

(II-1)

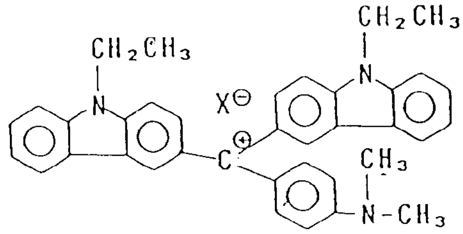

(II-2)

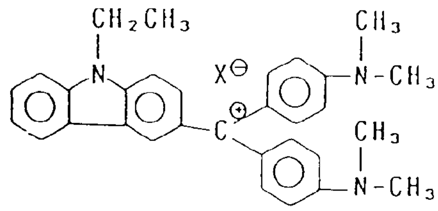

(II-3)

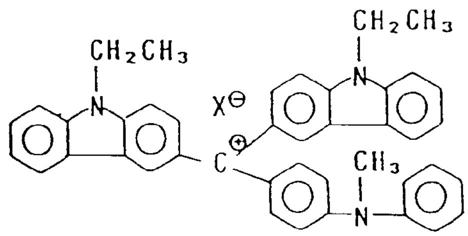

(II-4)

wherein X represents an anion such as chloride, bromide, iodide, chlorate and tetrafluoroborate.

**25.** A photosensitive material according to Claim 12, wherein said styryl base is any of the compounds of the following formulas.

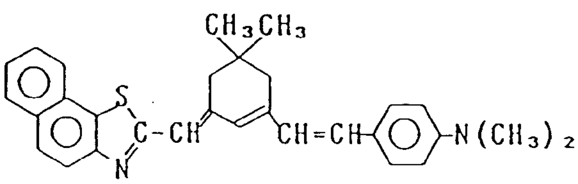

(III-1)

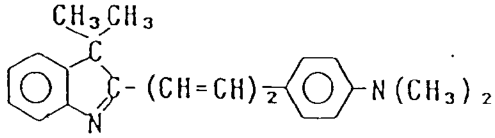

(III-2)

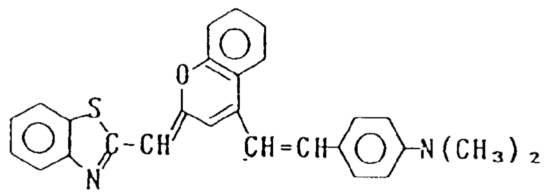

(III-3)

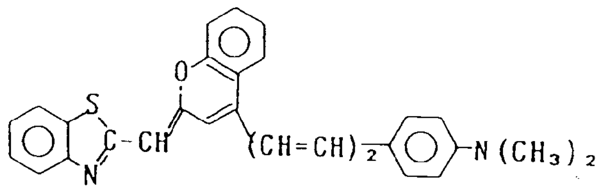

(III-4)

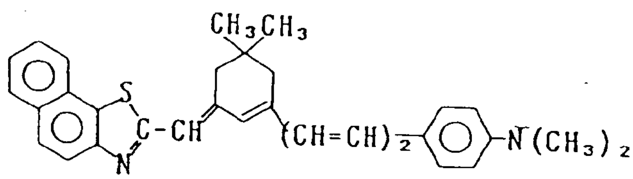

(III-5)

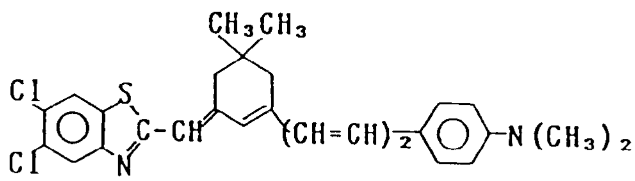

(III-6)

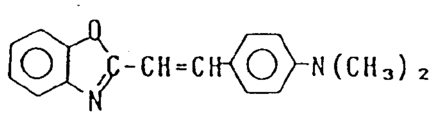

(III-7)

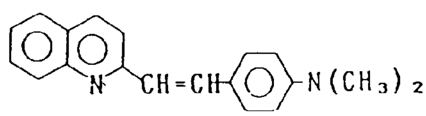

(III-8)

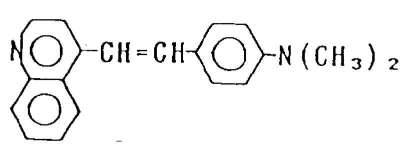

(III-9)

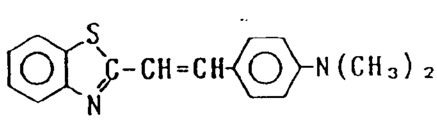

(III-10)

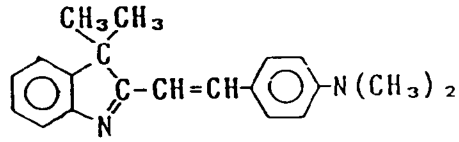

(III-11)

26. A method of preparing a volume type phase hologram, which comprises the steps of: subjecting a photosensitive material to exposure using a laser beam to form an interference pattern; and subjecting the photosensitive material thus exposed to light to development processing using a solvent, wherein a photosensitive material according to anyone of claims 12 to 16 or 19 to 25 is used.

27. A method of preparing a volume type phase hologram according to claim 26, wherein said laser beam is a beam of light with a wavelength of from 514.5 nm to 830 nm.

28. A method of preparing a volume type phase hologram according to claim 26, wherein the source of said laser beam is a semiconductor laser, a ruby laser, a helium-neon laser or an argon laser.

## Patentansprüche

1. Lichtempfindliche Harzzusammensetzung, umfassend:
   (a) Ein Polymer vom Polyvinylcarbazoltyp,
   (b) eine Halogen enthaltende Verbindung und
   (c) wenigstens eine Verbindung, die aus der Gruppe ausgewählt ist, bestehend aus einem Triarylhydrazyl, einem Triarylcarboniumartigen Färbematerial mit wenigstens einer Carbazolylgruppe und einem Reaktionsprodukt aus einer Styrylgrundlage und einem halogenierten Kohlenwasserstoff.

2. Lichtempfindliche Harzzusammensetzung nach Anspruch 1, worin die Zusammensetzung eine Empfindlichkeit gegenüber Licht vom sichtbaren bis in den nahen Infrarotwellenlängenbereich aufweist.

3. Lichtempfindliche Harzzusammensetzung nach Anspruch 1, worin die Komponente (a), die Komponente (b) und die Komponente (c) in einem Lösungsmittel gelöst sind.

4. Lichtempfindliche Harzzusammensetzung nach Anspruch 1, worin die Zusammensetzung die Form eines Filmes aufweist.

5. Lichtempfindliche Harzzusammensetzung nach Anspruch 1, worin die Komponente (b) in einem Anteil von 3 bis 25 Gew.-%, bezogen auf die Komponente (a), enthalten ist.

6. Lichtempfindliche Harzzusammensetzung nach Anspruch 1, worin die Komponente (c) in einem Anteil von 0,01 bis 25 Gew.-%, bezogen auf die Komponente (a), enthalten ist.

7. Lichtempfindliche Harzzusammensetzung nach Anspruch 1, worin das Triarylhydrazyl eine Verbindung darstellt, die durch die folgende Strukturformel dargestellt ist:

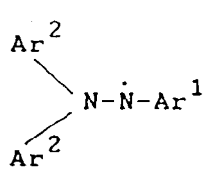

worin $Ar^1$ und $Ar^2$ jeweils unabhängig voneinander eine substituierte oder unsubstituierte Arylgruppe darstellen.

8. Lichtempfindliche Harzzusammensetzung nach Anspruch 1, worin das Triarylhydrazyl eine beliebige Verbindung der folgenden Formeln (I-1), (I-2) und (I-3) darstellt:

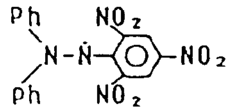

(I-1)

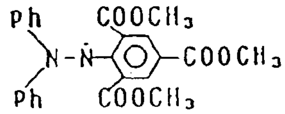

(I-2)

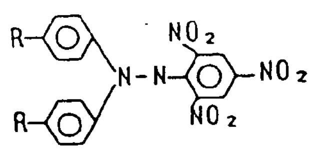

(I-3)

worin R einen Substituenten, wie zum Beispiel ein Halogenatom, eine niedrige Alkylgruppe, eine Alkoxycarbonylgruppe, eine Hydroxylgruppe oder eine Alkoxygruppe und Ph eine Phenylgruppe darstellt.

**9.** Lichtempfindliche Harzzusammensetzung nach Anspruch 1, worin das Färbematerial vom Triarylcarboniumtyp eine Verbindung darstellt, die durch die folgende Strukturformel dargestellt ist:

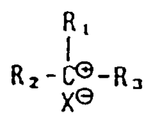

worin $R_1$ bis $R_3$ unabhängig voneinander eine aromatische Gruppe mit einem Halogenatom, eine Alkylgruppe, wie zum Beispiel eine Methylgruppe oder eine Ethylgruppe, eine Alkoxygruppe, wie zum Beispiel eine Methoxygruppe oder eine Ethoxygruppe, eine Aminogruppe, eine substituierte Aminogruppe, wie zum Beispiel eine Monomethylaminogruppe, eine Monoethylaminogruppe, eine Dimethylaminogruppe oder eine Diethylaminogruppe, eine Carboxylgruppe oder eine Sulfonsäuregruppe darstellen, mit der Voraussetzung, daß wenigstens einer der Reste $R_1$, $R_2$ und $R_3$ eine Carbazolylgruppe darstellt, und X ein Anion darstellt, wie zum Beispiel ein Chlorid, ein Bromid, ein Iodid, ein Chlorat oder ein Tetrafluorborat.

**10.** Lichtempfindliche Harzzusammensetzung nach Anspruch 1, worin das Färbematerial vom Triarylcarboniumtyp eine beliebige Verbindung der folgenden Formeln (II-1), (II-2), (II-3) und (II-4) darstellt:

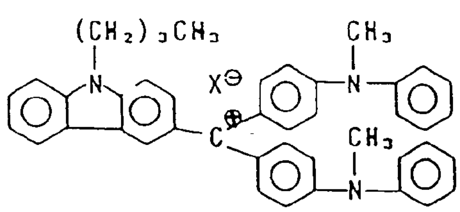

(II-1)

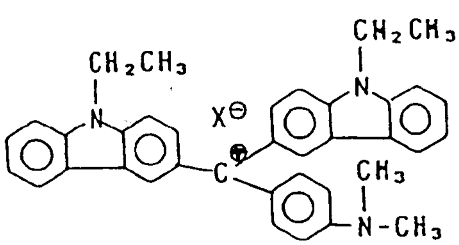

(II-2)

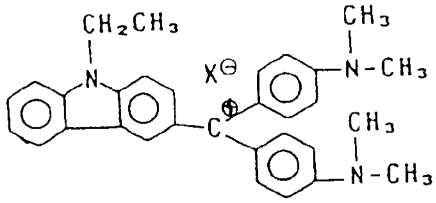

(II-3)

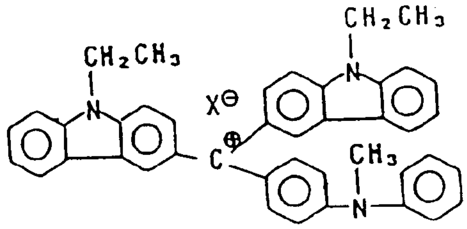

(II-4)

worin X ein Anion darstellt, wie zum Beispiel ein Chlorid, ein Bromid, ein Iodid, ein Chlorat oder ein Tetrafluorborat.

**11.** Lichtempfindliche Harzzusammensetzung nach Anspruch 1, worin die Styrylgrundlage eine beliebige Verbindung der folgenden Formeln darstellt:

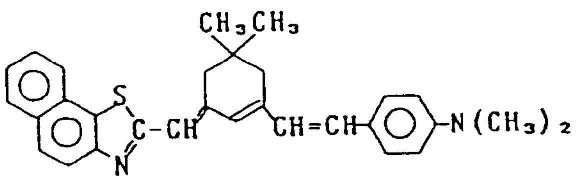

(III-1)

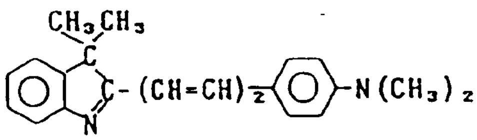

(III-2)

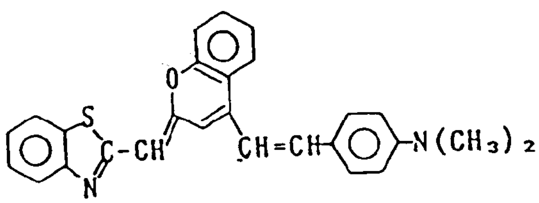

(III-3)

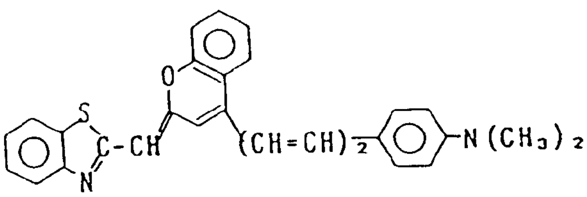

(III-4)

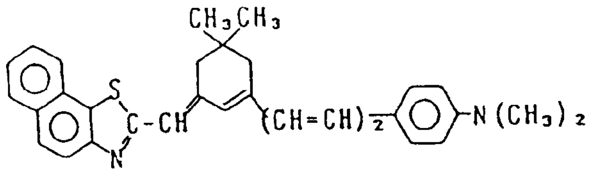

(III-5)

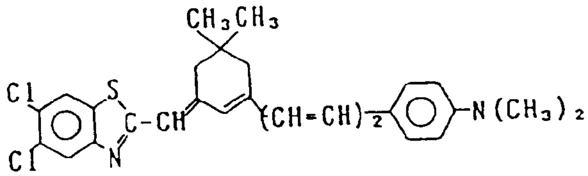

(III-6)

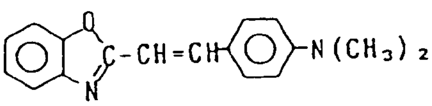

(III-7)

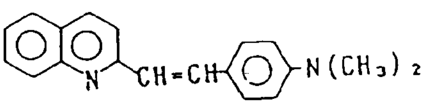

(III-8)

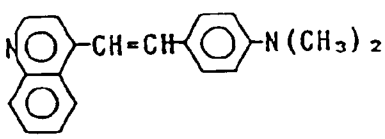

(III-9)

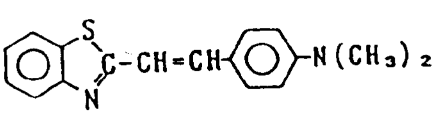

(III-10)

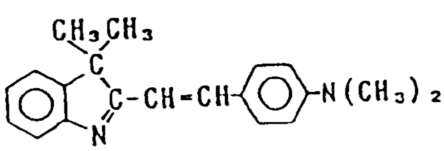

(III-11)

**12.** Lichtempfindliches Material, umfassend eine lichtempfindliche Schicht, die eine Harzzusammensetzung

nach Anspruch 1 umfaßt.

**13.** Lichtempfindliches Material nach Anspruch 12, worin die lichtempfindliche Schicht so bereit gestellt wird, daß sie eine Dicke von 1 µm bis 40 µm als Trokkenfilmdicke aufweist.

**14.** Lichtempfindliches Material nach Anspruch 12, worin die lichtempfindliche Schicht auf einem Träger bereitgestellt ist.

**15.** Lichtempfindliches Material nach Anspruch 12, worin die lichtempfindliche Schicht einen Beschichtungsfilm umfaßt.

**16.** Lichtempfindliches Material nach Anspruch 12, das in Form eines Filmes vorliegt.

**17.** Lichtempfindliches Material nach Anspruch 12, worin die lichtempfindliche Schicht eine Empfindlichkeit gegenüber Licht vom sichtbaren bis zum nahen Infrarotwellenlängenbereich aufweist.

**18.** Lichtempfindliches Material nach Anspruch 12, worin die lichtempfindliche Schicht eine Empfindlichkeit gegenüber Licht eines Wellenlängenbereiches von 514,5 nm bis 830 nm aufweist.

**19.** Lichtempfindliches Material nach Anspruch 12, worin die Komponente (b) in einem Anteil von 3 bis 25 Gew.-%, bezogen auf die Komponente (a), enthalten ist.

**20.** Lichtempfindliches Material nach Anspruch 12, worin die Komponente (c) in einem Anteil von 0,01 bis 25 Gew.-%, bezogen auf die Komponente (a), enthalten ist.

**21.** Lichtempfindliches Material nach Anspruch 12, worin das Triarylhydrazyl eine Verbindung darstellt, die durch die folgende Strukturformel dargestellt ist:

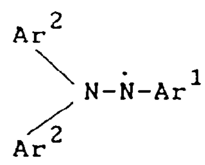

worin $Ar^1$ und $Ar^2$ jeweils unabhängig voneinander eine substituierte oder unsubstituierte Arylgruppe darstellen.

**22.** Lichtempfindliches Material nach Anspruch 12, worin das Triarylhydrazyl eine beliebige Verbindung der folgenden Formeln (I-1), (I-2) und (I-3) darstellt:

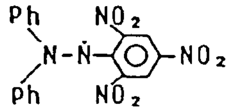

(I-1)

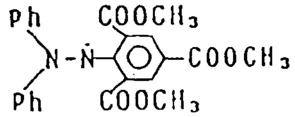

(I-2)

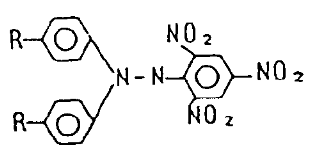

(I-3)

worin R einen Substituenten, wie zum Beispiel ein Halogenatom, eine niedrige Alkylgruppe, eine Alkoxycarbonylgruppe, eine Hydroxylgruppe oder eine Alkoxygruppe und Ph eine Phenylgruppe darstellt.

**23.** Lichtempfindliches Material nach Anspruch 12, worin das Färbematerial vom Triarylcarboniumtyp eine Verbindung darstellt, die durch die folgende Strukturformel dargestellt ist:

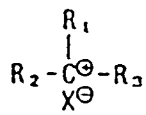

worin $R_1$ bis $R_3$ unabhängig voneinander eine aromatische Gruppe mit einem Halogenatom, eine Alkylgruppe, wie zum Beispiel eine Methylgruppe oder eine Ethylgruppe, eine Alkoxygruppe, wie zum Beispiel eine Methoxygruppe oder eine Ethoxygruppe, eine Aminogruppe, eine substituierte Aminogruppe, wie zum Beispiel eine Monomethylaminogruppe, eine Monoethylaminogruppe, eine Dimethylaminogruppe oder eine Diethylaminogruppe, eine Carboxylgruppe oder eine Sulfonsäuregruppe darstellen, mit der Voraussetzung, daß wenigstens einer der Reste $R_1$, $R_2$ und $R_3$ eine Carbazolylgruppe darstellt, und X ein Anion darstellt, wie zum Beispiel ein Chlorid, ein Bromid, ein Iodid, ein Chlorat oder ein Tetrafluorborat.

**24.** Lichtempfindliches Material nach Anspruch 12, worin das Färbematerial vom Triarylcarboniumtyp eine beliebige Verbindung der folgenden Formeln (II-1), (II-2), (II-3) und (II-4) darstellt:

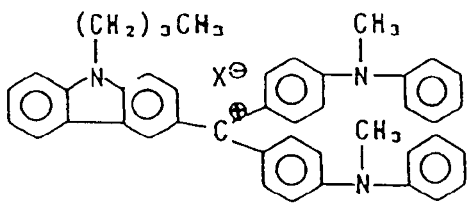

(II-1)

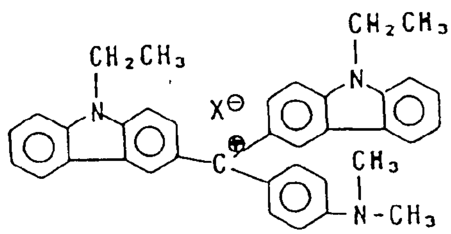

(II-2)

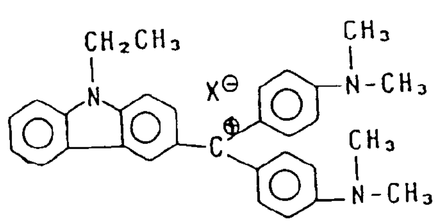

(II-3)

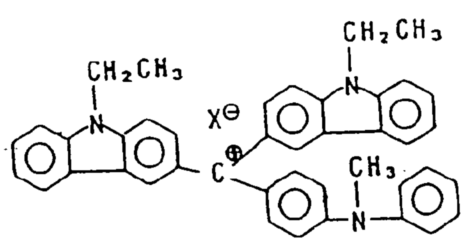

(II-4)

worin X ein Anion darstellt, wie zum Beispiel ein Chlorid, ein Bromid, ein Iodid, ein Chlorat oder ein Tetrafluorborat.

**25.** Lichtempfindliches Material nach Anspruch 12, worin die Styrylgrundlage eine beliebige Verbindung der

folgenden Formeln darstellt:

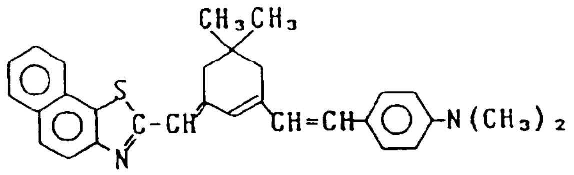

(III-1)

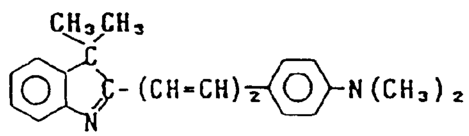

(III-2)

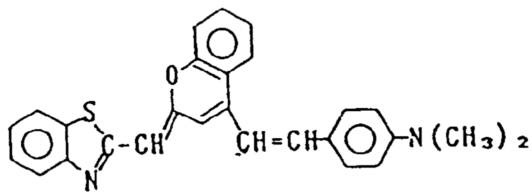

(III-3)

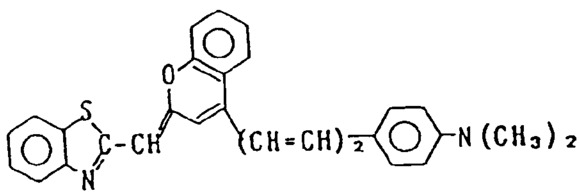

(III-4)

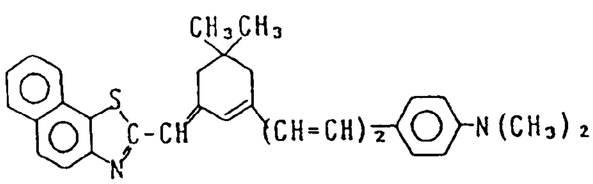

(III-5)

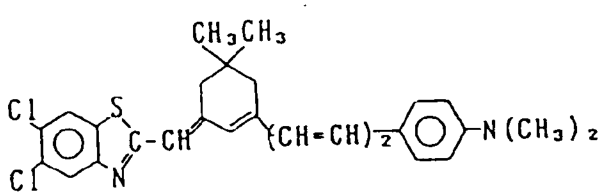

(III-6)

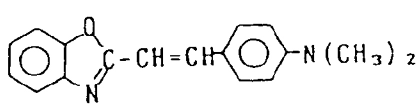

(III-7)

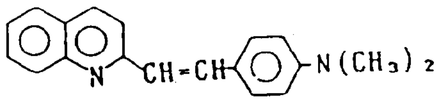

(III-8)

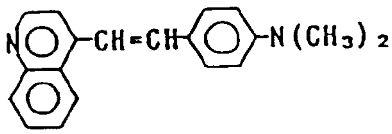

(III-9)

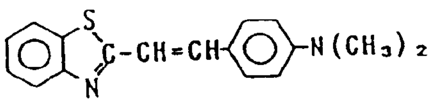

(III-10)

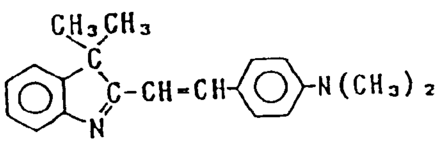

(III-11)

26. Verfahren zur Herstellung eines Phasenhologrammes vom Volumentyp, das folgende Schritte umfaßt:
    - Belichten eines lichtempfindlichen Materials unter Verwendung eines Laserstrahls zur Bildung eines Interferenzmusters und
    - Unterziehen des so belichteten, lichtempfindlichen Materials einer Entwicklungsbehandlung unter Verwendung eines Lösungsmittels, worin ein lichtempfindliches Material nach einem der Ansprüche 12 bis 16 oder 19 bis 25 verwendet wird.

27. Verfahren zur Herstellung eines Phasenhologrammes vom Volumentyp nach Anspruch 26, worin der Laserstrahl ein Lichtstrahl mit einer Wellenlänge von 514,5 nm bis 830 nm ist.

28. Verfahren zur Herstellung eines Phasenhologrammes vom Volumentyp nach Anspruch 26, worin die Quelle des Laserstrahls ein Halbleiterlaser, ein Rubinlaser, ein Helium-Neon-Laser oder ein Argonlaser ist.

## Revendications

1. Composition de résine photosensible, comprenant :
   (a) un polymère du type polyvinylcarbazole ;
   (b) un composé contenant un halogène ; et
   (c) au moins un composé choisi dans le groupe consistant en un triarylhydrazyle, une matière colorante du type triarylcarbonium portant au moins un groupe carbazolyle, et un produit de réaction d'une base styrylique avec un hydrocarbure halogéné.

2. Composition de résine photosensible suivant la revendication 1, qui a une sensibilité à la lumière dans des régions de longueurs d'ondes allant de la lumière visible au proche infrarouge.

3. Composition de résine photosensible suivant la revendication 1, dans laquelle le composant (a), le composant (b) et le composant (c) sont dissous dans un solvant.

4. Composition de résine photosensible suivant la revendication 1, qui est sous la forme d'un film.

5. Composition de résine photosensible suivant la revendication 1, dans laquelle le composant (b) est présent dans une proportion en poids de 3 à 25 % sur la base du composant (a) concerné.

6. Composition de résine photosensible suivant la revendication 1, dans laquelle le composant (c) est présent dans une proportion en poids de 0,01 à 25 % en poids sur la base du composant (a) concerné.

7. Composition de résine photosensible suivant la revendication 1, dans laquelle le triarylhydrazyle est un composé représenté par la formule structurale suivante :

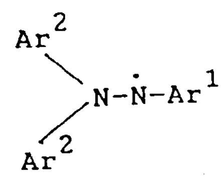

dans laquelle $Ar^1$ et $Ar^2$ représentent, indépendamment, un groupe aryle substitué ou non substitué.

8. Composition de résine photosensible suivant la revendication 1, dans laquelle le triarylhydrazyle est l'un quelconque des composés de formules (I-1), (I-2) et (I-3) :

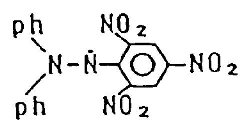

(I-1)

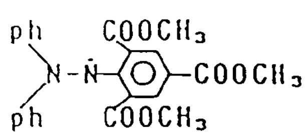

(I-2)

(I-3)

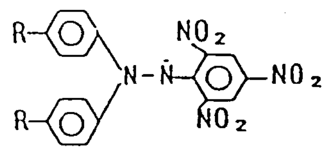

dans lesquelles R représente un substituant tel qu'un atome d'halogène, un groupe alkyle inférieur, un groupe alkoxycarbonyle, un groupe hydroxyle et un groupe alkoxy ; et ph représente un groupe phényle.

9. Composition de résine photosensible suivant la revendication 1, dans laquelle la matière colorante du type triarylcarbonium est un composé représenté par la formule structurale suivante :

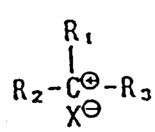

dans laquelle $R_1$ à $R_3$ représentent, indépendamment, un groupe aromatique portant un atome d'halogène, un groupe alkyle tel qu'un groupe méthyle et un groupe éthyle, un groupe alkoxy tel qu'un groupe méthoxy et un groupe éthoxy, un groupe amino, un groupe amino substitué tel qu'un groupe monométhylamino, un groupe monoéthylamino, un groupe diméthylamino et un groupe diéthylamino, un groupe carboxyle ou un groupe acide sulfonique, sous réserve que l'un au moins de $R_1$, $R_2$ et $R_3$ soit un groupe carbazolyle ; et X représente un anion tel que chlorure, bromure, iodure, chlorate et tétrafluoroborate.

**10.** Composition de résine photosensible suivant la revendication 1, dans laquelle la matière colorante du type triarylcarbonium est l'un quelconque des composés de formules (II-1), (II-2), (II-3) et (II-4) suivantes :

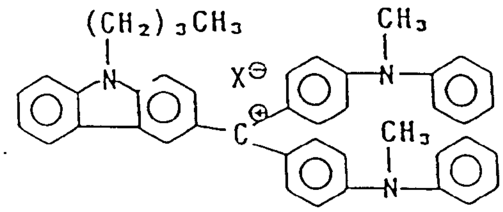

(II-1)

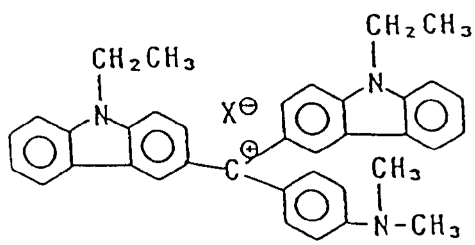

(II-2)

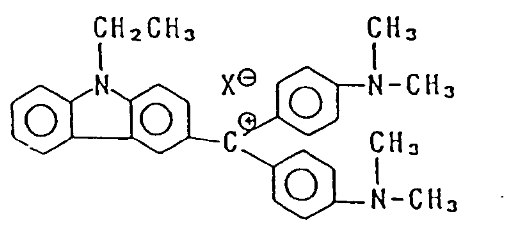

(II-3)

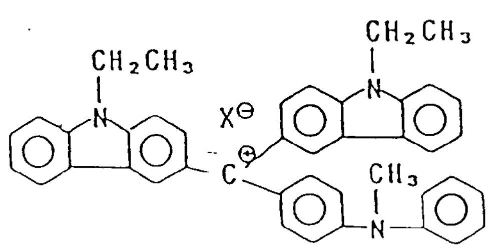

(II-4)

dans lesquelles X représente un anion tel que chlorure, bromure, iodure, chlorate et tétrafluoroborate.

**11.** Composition de résine photosensible suivant la revendication 1, dans laquelle la base styrylique est l'un quelconque des composés de formules suivantes :

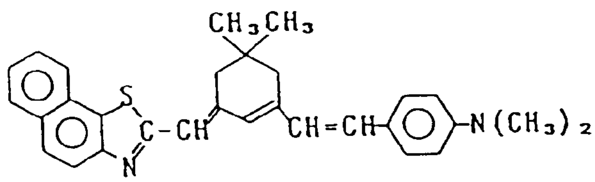
(III-1)

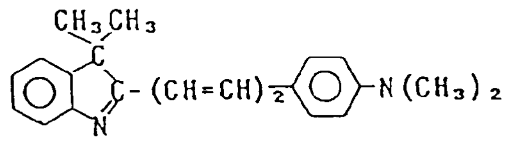
(III-2)

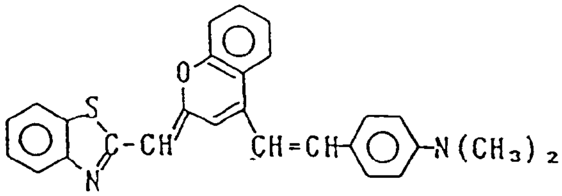
(III-3)

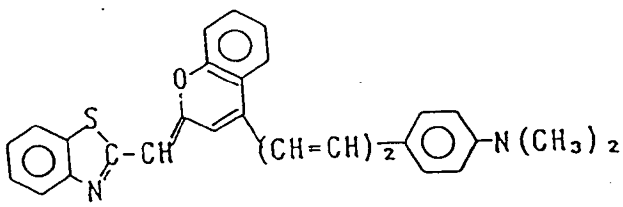
(III-4)

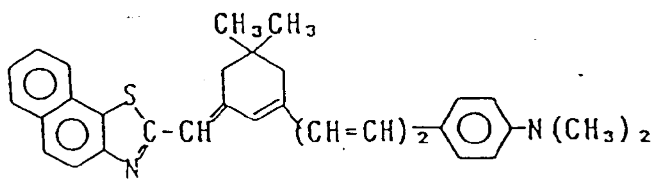
(III-5)

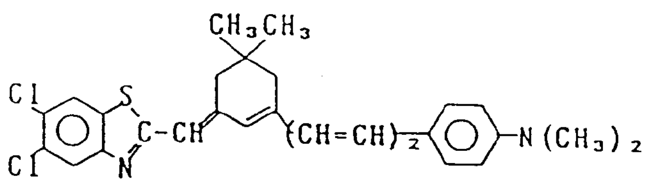
(III-6)

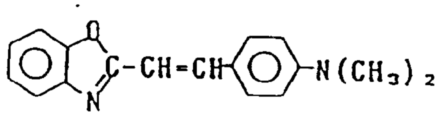
(III-7)

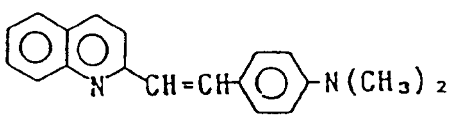
(III-8)

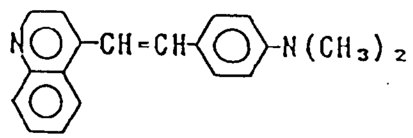

(III-9)

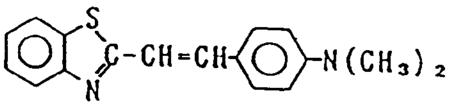

(III-10)

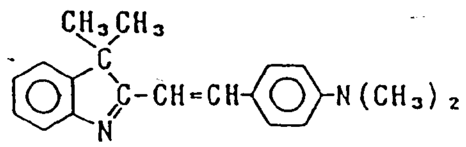

(III-11)

**12.** Matière photosensible, qui comprend une couche photosensible comprenant une composition de résine suivant la revendication 1.

**13.** Matière photosensible suivant la revendication 12, dans laquelle la couche photosensible est prévue de manière à avoir une épaisseur de 1 μm à 40 μm à l'état de film séché.

**14.** Matière photosensible suivant la revendication 12, dans laquelle la couche photosensible est portée par un substrat.

**15.** Matière photosensible suivant la revendication 12, dans laquelle la couche photosensible comprend un film de revêtement.

**16.** Matière photosensible suivant la revendication 12, qui est sous la forme d'un film.

**17.** Matière photosensible suivant la revendication 12, dans laquelle la couche photosensible est douée de sensibilité à la lumière dans les régions de longueurs d'ondes allant de la lumière visible au proche infrarouge.

**18.** Matière photosensible suivant la revendication 12, dans laquelle la couche photosensible est douée de sensibilité à la lumière d'une région de longueur d'ondes de 514,5 nm à 830 nm.

**19.** Matière photosensible suivant la revendication 12, dans laquelle le composant (b) est présent dans la proportion de 3 à 25 % en poids sur la base du composant (a) concerné.

**20.** Matière photosensible suivant la revendication 12, dans laquelle le composant (c) est présent dans la proportion de 0,01 à 25 % en poids sur la base du composant (a) concerné.

**21.** Matière photosensible suivant la revendication 12, dans laquelle le triarylhydrazyle est un composé représenté par la formule structurale suivante :

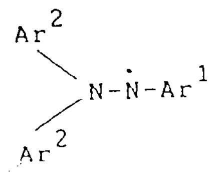

dans laquelle $Ar^1$ et $Ar^2$ représentent, indépendamment, un groupe aryle substitué ou non substitué.

**22.** Matière photosensible suivant la revendication 12, dans laquelle le triarylhydrazyle est l'un quelconque des composés des formules (I-1), (I-2) et (I-3) suivantes :
(I-3):

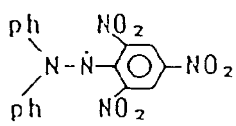

(I-1)

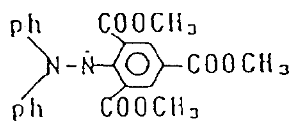

(I-2)

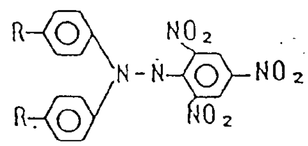

(I-3)

dans lesquelles R représente un substituant tel qu'un atome d'halogène, un groupe alkyle inférieur, un groupe alkoxycarbonyle, un groupe hydroxyle et un groupe alkoxy ; et ph représente un groupe phényle.

**23.** Matière photosensible suivant la revendication 12, dans laquelle la matière colorante du type triarylcarbonium est un composé représenté par la formule structurale suivante :

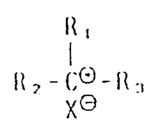

dans laquelle $R_1$ à $R_3$ représentent, indépendamment, un groupe aromatique portant un atome d'halogène, un groupe alkyle tel qu'un groupe méthyle et un groupe éthyle, un groupe alkoxy tel qu'un groupe méthoxy et un groupe éthoxy, un groupe amino, un groupe amino substitué tel qu'un groupe monométhylamino, un groupe monoéthylamino, un groupe diméthylamino et un groupe diéthylamino, un groupe carboxyle ou un groupe acide sulfonique, sous réserve que l'un au moins de $R_1$, $R_2$ et $R_3$ soit un groupe carbazolyle ; et X représente un anion tel que chlorure, bromure, iodure, chlorate et tétrafluoroborate.

**24.** Matière photosensible suivant la revendication 12, dans laquelle la matière colorante du type triarylcarbonium est l'un quelconque des composés des formules (II-1), (II-2), (II-3) et (II-4) :

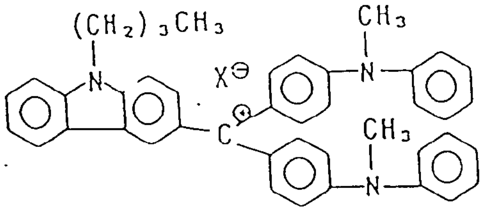

(II-1)

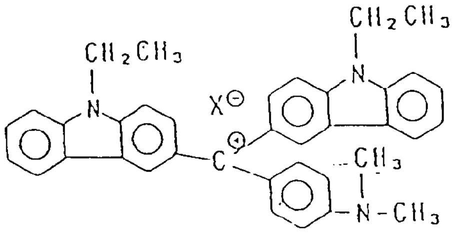

(II-2)

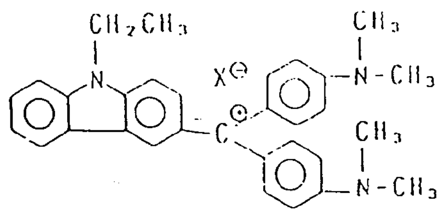

(II-3)

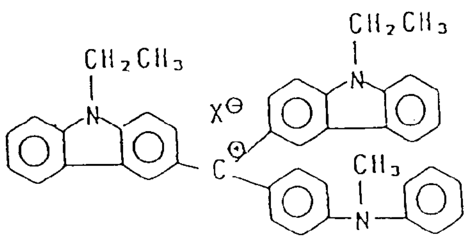

(II-4)

dans lesquelles X représente un anion tel que chlorure, bromure, iodure, chlorate et tétrafluoroborate.

**25.** Matière photosensible suivant la revendication 12, dans laquelle la base styrylique est l'un quelconque des composés de formules suivantes

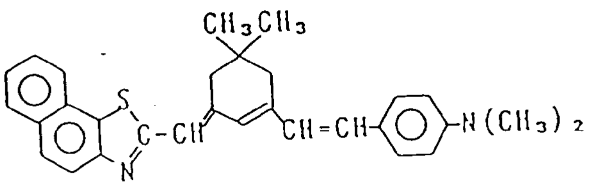

(III-1)

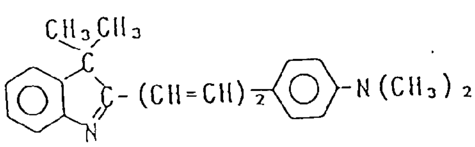

(III-2)

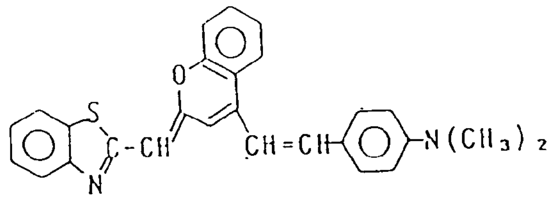

(III-3)

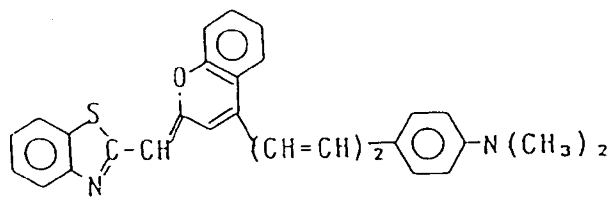

(III-4)

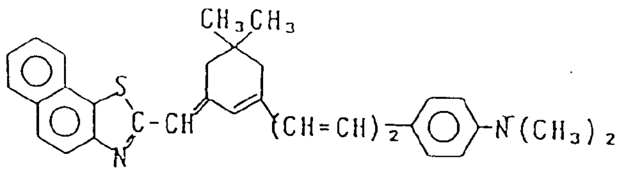

(III-5)

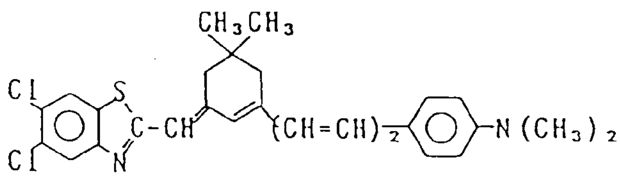

(III-6)

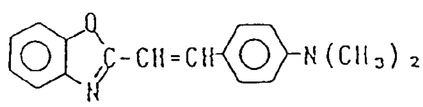

(III-7)

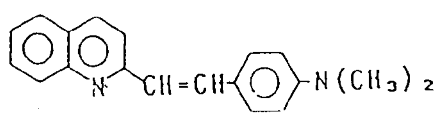

(III-8)

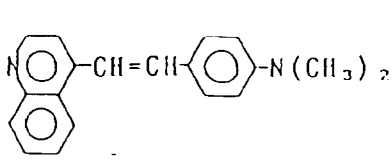

(III-9)

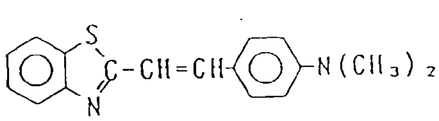

(III-10)

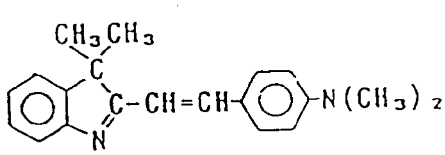

(III-11)

**26.** Procédé de production d'un hologramme de phase du type en volume, qui comprend les étapes consistant :

à soumettre une matière photosensible à une exposition en utilisant un faisceau laser pour former une image par interférence ; et

à soumettre la matière photosensible ainsi exposée à la lumière à un traitement de développement utilisant un solvant,

dans lequel est utilisée une matière photosensible suivant l'une quelconque des revendications 12 à 16 ou 19 à 25.

**27.** Procédé de production d'un hologramme de phase du type en volume suivant la revendication 26, dans lequel le faisceau laser est un faisceau de lumière d'une longueur d'onde de 514,5 nm à 830 nm.

**28.** Procédé de production d'un hologramme de phase du type en volume suivant la revendication 26, dans lequel la source du faisceau laser est un laser à semi-conducteur, un laser à rubis, un laser à hélium-néon ou un laser à argon.

FIG. 1

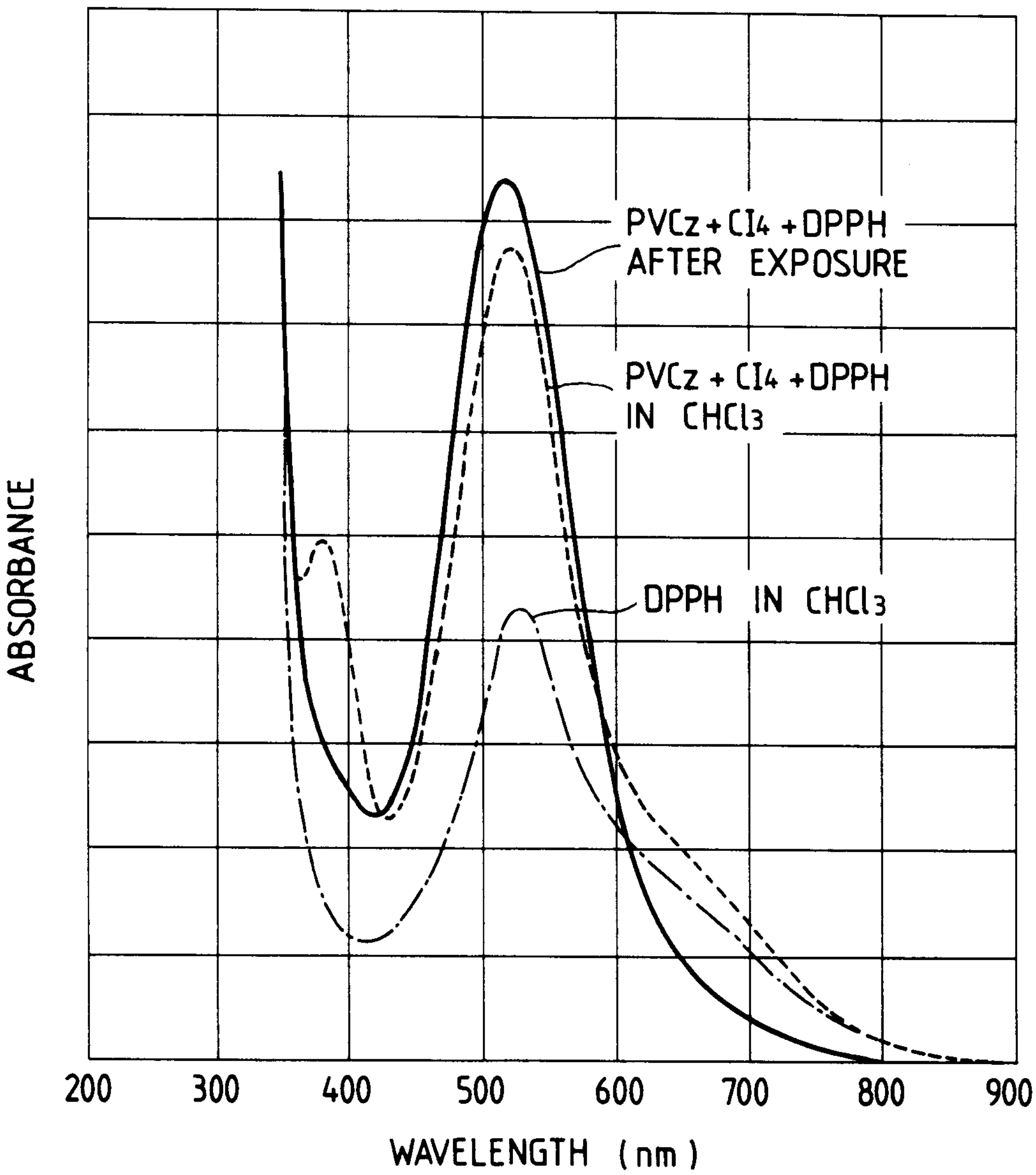
PVCz + CI4 + DPPH
AFTER EXPOSURE
PVCz + CI4 + DPPH
IN CHCl3
DPPH IN CHCl3
ABSORBANCE
200
300
400
500
600
700
800
900
WAVELENGTH (nm)

FIG. 2

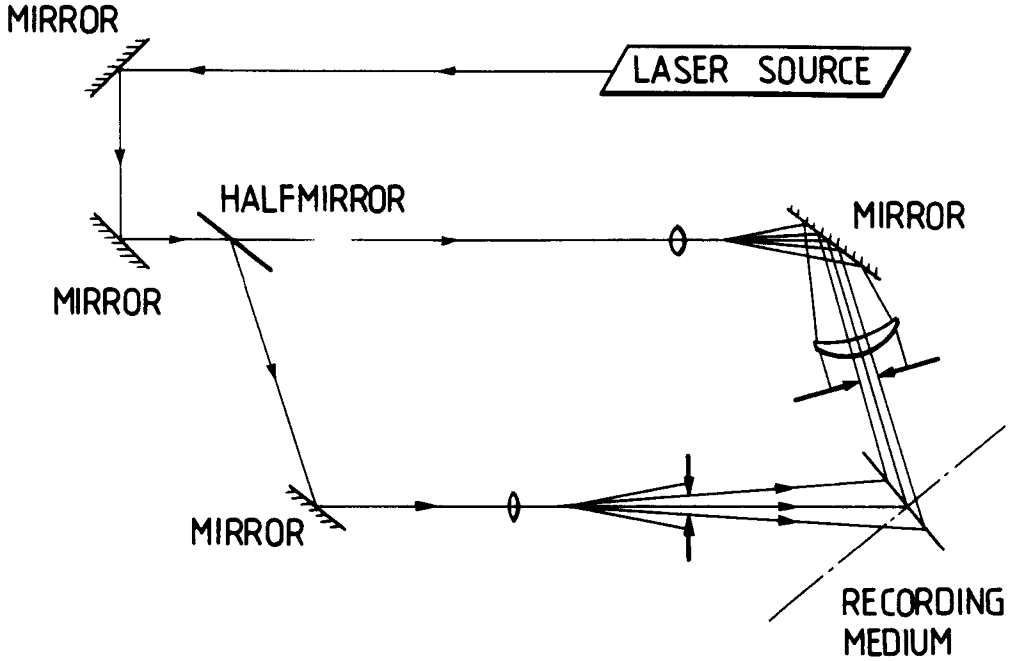
MIRROR
LASER SOURCE
HALFMIRROR
MIRROR
MIRROR
MIRROR
RECORDING MEDIUM

FIG. 3

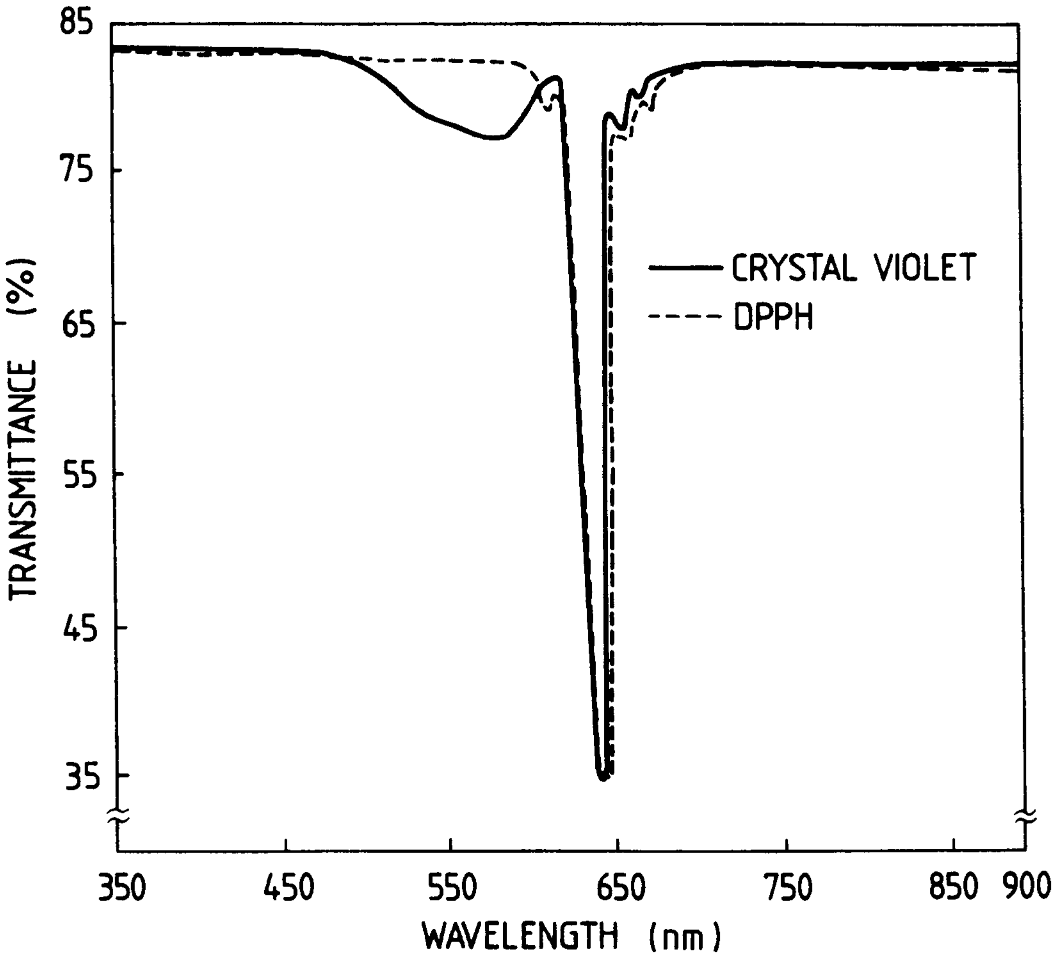
85
75
65
55
45
35
TRANSMITTANCE (%)
CRYSTAL VIOLET
DPPH
350
450
550
650
750
850
900
WAVELENGTH (nm)

FIG. 4

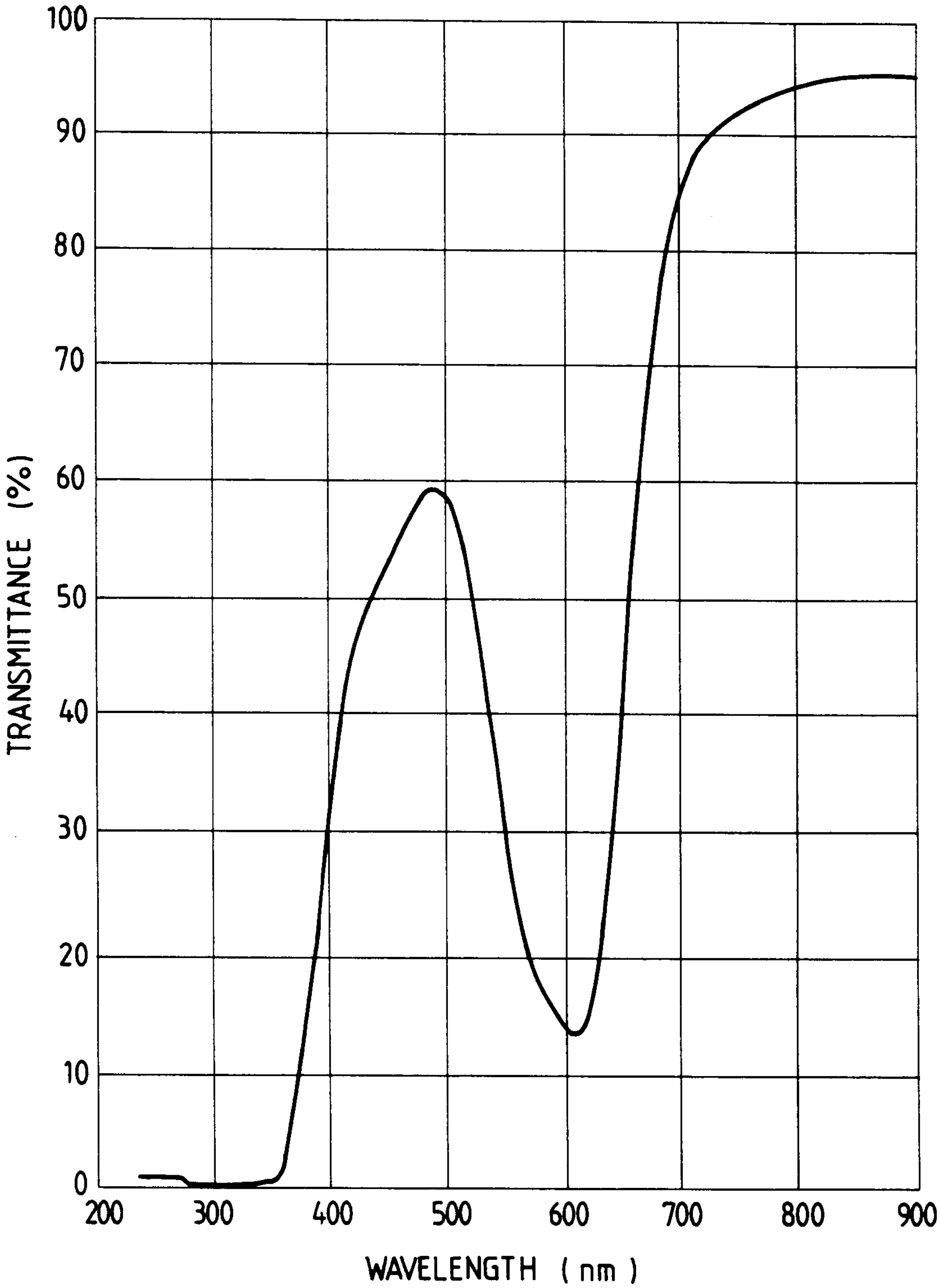
100
90
80
70
60
50
40
30
20
10
0
TRANSMITTANCE (%)
200
300
400
500
600
700
800
900
WAVELENGTH ( nm )